# EUROPEAN PATENT SPECIFICATION

(11) **EP 4 020 526 B1**
(45) Date of publication and mention of the grant of the patent: **22.05.2024**
(21) Application number: 21865347.5
(22) Date of filing: 02.08.2021
(51) Int. Cl.: H01L 21/033, H01L 21/311

(54) **SEMICONDUCTOR FABRICATION METHOD**
VERFAHREN ZUR HERSTELLUNG EINES HALBLEITERBAUELEMENTS
PROCÉDÉ DE FABRICATION D'UN DISPOSITIF À SEMI-CONDUCTEUR

(30) Priority: 12.11.2020 CN 202011259983
(43) Date of publication of application: 29.06.2022
(73) Proprietor: Changxin Memory Technologies, Inc., Hefei City, Anhui 230000 (CN)
(72) Inventor: ZHANG, Chuanyang, Hefei Anhui 230000 (CN)
(74) Representative: Lavoix
(86) International application number: PCT/CN2021/110066
(87) International publication number: WO 2022/100158

(56) References cited:
- CN-A- 102 205 942
- CN-A- 105 185 838
- JP-A- 2012 213 967
- US-A1- 2011 223 756
- US-A1- 2019 244 815
- US-B1- 7 078 334

## Description

### Technical Field

The present disclosure relates to, but is not limited to, a semiconductor device and a method of manufacturing a semiconductor device.

### Background

During manufacturing of a semiconductor device, as an important method of pattern transfer, a photolithography process is widely applied. As a size of the semiconductor device continues to shrink, the pattern transfer in the photolithography process is also required to be increasingly accurate. When a photoresist (PR) is coated for exposure in a front-end photolithography process during the manufacturing of the semiconductor device, accuracy of the pattern transfer is not high, reducing quality of the semiconductor device.

US2019244815A1 discloses a hard mask and a method of creating thereof. CN105185838A discloses a thin film transistor and a manufacturing method thereof.

### Summary

An overview of the subject matter detailed in the present disclosure is provided below, which is not intended to limit the protection scope of the claims.

The present disclosure provides a semiconductor device and a method of manufacturing semiconductor device, to improve accuracy of pattern transfer.

According to a first aspect of the present disclosure, a method of manufacturing a semiconductor device is provided, where the method of manufacturing a semiconductor device includes:
providing a substrate, where the substrate includes an array region and an edge region;
forming a composite layer on the substrate, where the composite layer includes an amorphous silicon layer and a silicon dioxide layer, and the silicon dioxide layer is located on a surface of the amorphous silicon layer away from the substrate;
dry etching the silicon dioxide layer in the array region by using first plasma, to expose a part of the surface of the amorphous silicon layer in the array region;
performing, by using second plasma, a plasma surface treatment on an exposed part of the surface of the amorphous silicon layer;
cleaning an amorphous silicon layer on which the plasma surface treatment has been performed and a dry etched silicon dioxide layer; and
coating a first photoresist layer on the composite layer in the edge region and the array region, and performing exposing and developing.

Other aspects of the present disclosure are understandable upon reading and understanding of the drawings and detailed description.

### Brief Description of the Drawings

The drawings incorporated into the specification and constituting a part of the specification illustrate the embodiments of the present disclosure, and are used together with the descriptions to explain the principles of the embodiments of the present disclosure. In these drawings, similar reference numerals are used to represent similar elements. The drawings in the following descriptions are some rather than all of the embodiments of the present disclosure. Those skilled in the art may derive other drawings based on these drawings without creative efforts.
FIG. 1 is a schematic structural diagram of a semiconductor device.
FIG. 2 is a schematic flowchart of a method of manufacturing a semiconductor device according to an implementation of the present disclosure.
FIG. 3 is a schematic diagram of hydrogen bonds on a surface of an amorphous silicon layer.
FIG. 4 is a schematic diagram of impurity particles and a labile compound on the surface of the amorphous silicon layer.
FIG. 5 is a schematic diagram of performing, by using second plasma, a plasma surface treatment on an exposed part of the surface of the amorphous silicon layer according to an implementation of the present disclosure.
FIG. 6 is a schematic diagram of cleaning the amorphous silicon layer on which the plasma surface treatment has been performed and a dry etched silicon dioxide layer according to an implementation of the present disclosure.
FIG. 7 is a schematic diagram of bonding of a first photoresist layer and an amorphous silicon layer after use of the method of manufacturing a semiconductor device according to an implementation of the present disclosure.

In the figures: 1. Semiconductor device; 11. Array region; 12. Edge region; 10. Substrate; 101. Wafer; 102. First silicon nitride layer; 103. Carbon layer; 104. Second silicon nitride layer; 20. Composite layer; 201. Amorphous silicon layer; 202. Silicon dioxide layer; 30. first photoresist layer; 40. Silicon oxide hard mask intermediate layer; 50. Second photoresist layer; 2. Impurity particle; 3. Labile compound.

### Detailed Description

The technical solutions in the embodiments of the present disclosure are described below clearly and completely with reference to the drawings in the embodiments of the present disclosure. Apparently, the described embodiments are merely part rather than all of the embodiments of the present disclosure. All other embodiments obtained by those skilled in the art based on the embodiments of the present disclosure without creative efforts should fall within the protection scope of the present disclosure. It should be noted that the embodiments in the present disclosure and features in the embodiments may be combined with each other in a non-conflicting manner.

A photolithography process is an important method of pattern transfer during manufacturing of a semiconductor device, and as a size of the semiconductor device continues to shrink, the pattern transfer in the photolithography process is also required to be increasingly accurate. After a PR is coated in a front-end photolithography process during actual manufacturing of a semiconductor device, a memory cell region of the semiconductor device produces pattern defects, which in turn leads to poor quality of the semiconductor device.

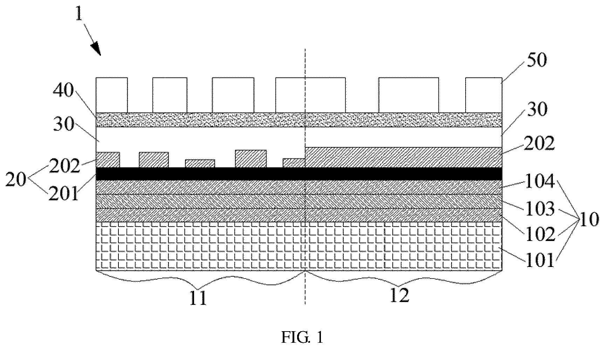

As shown in FIG. 1, the semiconductor device 1 is divided into an array region 11 and an edge region 12, and the edge region 12 may be round or square, or the like, which is not specially limited herein. The semiconductor device 1 includes a substrate 10, a composite layer 20, a first photoresist layer 30, a silicon oxide hard mask intermediate layer 40, and a second photoresist layer 50.

The substrate 10 may include a wafer 101 and a first silicon nitride layer 102, a carbon layer 103, and a second silicon nitride layer 104 sequentially laminated on the wafer 101. The composite layer 20 is formed on a surface of the substrate 10. The composite layer 20 includes an amorphous silicon layer 201 and a silicon dioxide layer 202, and the silicon dioxide layer 202 is located on a surface of the amorphous silicon layer 201 away from the substrate 10.

The silicon dioxide layer 202 in the array region 11 has a first preset pattern, and a part of the surface of the amorphous silicon layer 201 is exposed. The amorphous silicon layer 201 and the silicon dioxide layer 202 in the edge region 12 are flat film layers.

A first photoresist layer 30 is formed on the composite layer 20 in the edge region 12 and the array region 11, a silicon oxide hard mask intermediate layer 40 and a second photoresist layer 50 are sequentially formed on a surface of the first photoresist layer 30 away from the substrate 10, and the second photoresist layer 50 has a second preset pattern.

Because pattern defects are concentrated only in the array region 11 of the semiconductor device 1, the edge region 12 of the semiconductor device 1 has no defect. A difference between the array region 11 and the edge region 12 mainly lies in that a pattern is obtained through etching by an etching process performed on the silicon dioxide layer 202 (a hard mask layer) in the array region 11.

It is speculated that a reason for the pattern defects is that there are certain impurities on the surface of the etched amorphous silicon layer 201, and consequently, the first photoresist layer 30 cannot well adhere to the amorphous silicon layer 201 during a spin coating process. This reduces accuracy of pattern transfer and eventually causes pattern defects.

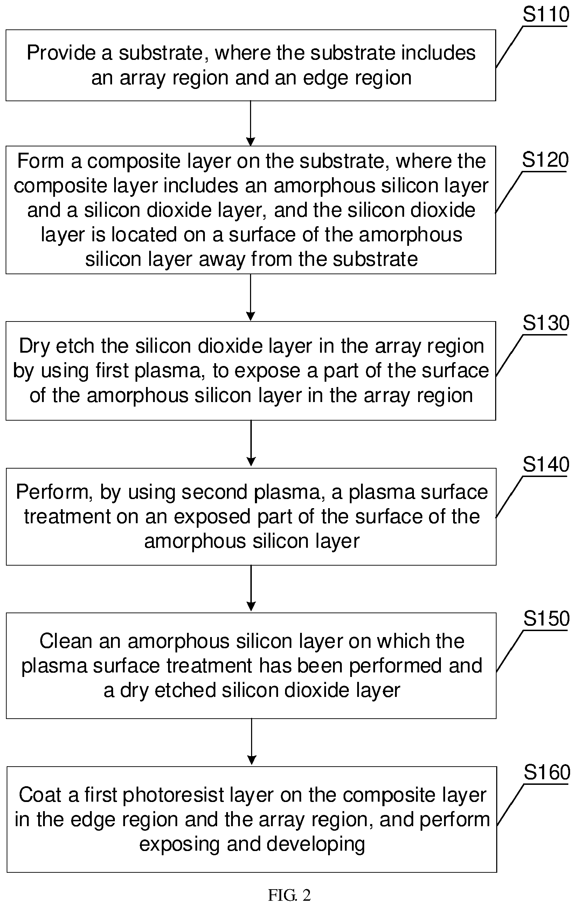

An implementation of the present disclosure provides a method of manufacturing a semiconductor device. As shown in FIG. 2, the method of manufacturing a semiconductor device may include the following steps:
Step S110. Provide a substrate, where the substrate includes an array region and an edge region.
Step S120. Form a composite layer on the substrate, where the composite layer includes an amorphous silicon layer and a silicon dioxide layer, and the silicon dioxide layer is located on a surface of the amorphous silicon layer away from the substrate.
Step S130. Dry etch the silicon dioxide layer in the array region by using first plasma, to expose a part of the surface of the amorphous silicon layer in the array region.
Step S140. Perform, by using second plasma, a plasma surface treatment on an exposed part of the surface of the amorphous silicon layer.
Step S150. Clean the amorphous silicon layer on which the plasma surface treatment has been performed and the dry etched silicon dioxide layer.
Step S160. Coat a first photoresist layer on the composite layer in the edge region and the array region, and perform exposing and developing.

The performing, by using second plasma, a plasma surface treatment on an exposed part of the surface of the amorphous silicon layer 201, on the one hand, can neutralize charges on the surface of the amorphous silicon layer 201, thereby removing impurity particles 2 due to electrostatic adsorption; and on the other hand, can remove a labile compound 3 on the surface of the amorphous silicon layer 201, and form a smooth hard layer on the surface of the amorphous silicon layer 201.

Subsequently, the amorphous silicon layer 201 on which the plasma surface treatment has been performed and the dry etched silicon dioxide layer 202 are cleaned. The method of manufacturing a semiconductor device improves adhesion between the surface of the amorphous silicon layer 201 and the first photoresist layer 30 in the array region 11, such that the amorphous silicon layer 201 can better adhere to the first photoresist layer 30, thereby improving accuracy of pattern transfer during photolithography, avoiding pattern defects, and thus improving quality of the semiconductor device 1.

A photolithography method provided in an implementation of the present disclosure is described in detail below with reference to the accompanying drawings.

In step S110, a substrate 10 is provided, where the substrate 10 may include a wafer 101 and a first silicon nitride layer 102, a carbon layer 103, and a second silicon nitride layer 104 sequentially laminated on the wafer 101. The first silicon nitride layer 102, the carbon layer 103, and the second silicon nitride layer 104 may be formed by using a chemical vapor deposition method.

In step S120, a composite layer 20 is formed on the substrate 10, where the composite layer 20 may include an amorphous silicon layer 201 and a silicon dioxide layer 202, and the silicon dioxide layer 202 is located on a surface of the amorphous silicon layer 201 away from the substrate 10.

A gaseous raw material of amorphous silicon is introduced into the chamber, and the amorphous silicon layer 201 is formed on the substrate 10. A gaseous raw material of silica is introduced into the chamber, and the silicon dioxide layer 202 is formed on the amorphous silicon layer 201. In this way, the composite layer 20 can be formed on the substrate 10.

In step S130, the silicon dioxide layer 202 in an array region 11 is dry etched by using first plasma, to expose a part of the surface of the amorphous silicon layer 201 in the array region 11, and the silicon dioxide layer 202 in the array region 11 is dry etched and a preset pattern is formed.

Before the silicon dioxide layer 202 in the array region 11 is dry etched by using the first plasma, the method of manufacturing the semiconductor device in this implementation of the present disclosure further includes:
ionizing a first gas in a chamber, to form the first plasma, so as to dry etch the silicon dioxide layer 202. The first gas may be hexafluorobutadiene (C₄F₆) or octafluorocyclobutane (C₄F₈) with oxygen, that is, the first gas may be a mixed gas of oxygen and octafluorocyclobutane or a mixed gas of oxygen and hexafluorobutadiene.

In step S140, a plasma surface treatment is formed, by using second plasma, on an exposed part of the surface of the amorphous silicon layer 201.

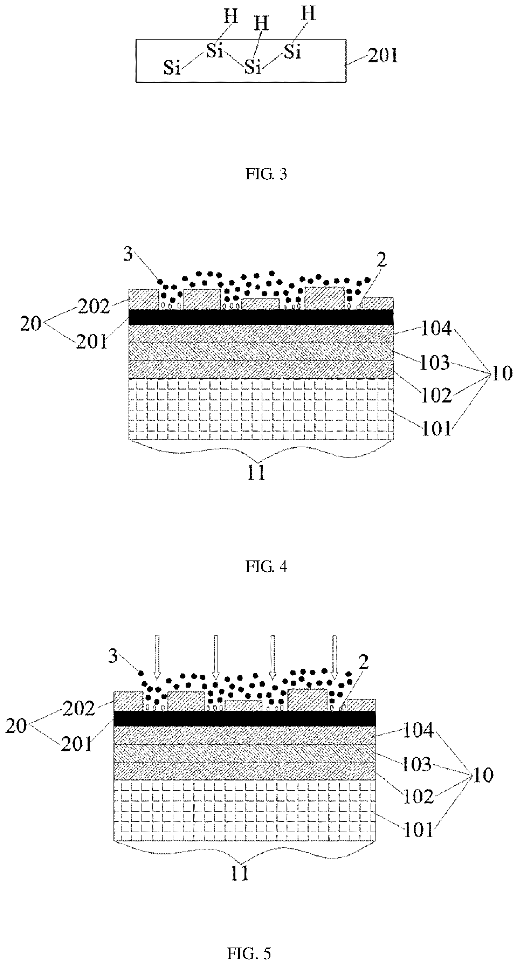

As shown in FIG. 3, the surface of the amorphous silicon layer 201 has hydrogen bonds, and positive charges carried by the hydrogen bonds have a certain absorption effect on dust. Therefore, impurity particles 2 are attached to the surface of the amorphous silicon layer 201 (as shown in FIG. 4). In addition, after the silicon dioxide layer 202 in the array region 11 is dry etched by using the first plasma, because gas plasma used is a high-energy particle aggregate with high chemical reactivity, particles react with each other and the labile compound 3 is formed (as shown in FIG. 4).

The impurity particles 2 and the labile compound 3 work together, and consequently, the first photoresist layer 30 cannot better adhere to the amorphous silicon layer 201 during a spin coating process. This reduces accuracy of pattern transfer.

As shown in FIG. 5, the performing, by using second plasma, a plasma surface treatment on an exposed part of the surface of the amorphous silicon layer 201, on the one hand, can neutralize hydrogen bonds on the surface of the amorphous silicon layer 201, thereby removing impurity particles 2 due to electrostatic adsorption; and on the other hand, can remove the labile compound 3 on the surface of the amorphous silicon layer 201, thereby facilitating adhesion of the first photoresist layer 30.

Before the performing, by using second plasma, a plasma surface treatment on an exposed part of the surface of the amorphous silicon layer 201, the method of manufacturing the semiconductor device in this implementation of the present disclosure may further include:
ionizing a second gas in the chamber, to form the second plasma, thereby performing the plasma surface treatment on an exposed part of the surface of the amorphous silicon layer 201. The second gas may be nitrous oxide or helium, which is not specially limited herein.

Because plasma particles formed by nitrous oxide or helium contain nitrogen, and nitrogen reacts in a superficial layer of the amorphous silicon layer 201 to produce a SiN-like composition, a smooth hard layer is formed on the surface of the amorphous silicon layer 201, which in turn improves adhesion of the first photoresist layer 30 on the amorphous silicon layer 201.

When the second gas is nitrous oxide, a gas flow rate of the second gas may be 4000 standard ml/min to 6000 standard ml/min. When the second gas is helium, the gas flow rate of the second gas may be 1000 standard ml/min to 3000 standard ml/min. In addition, a value of radio frequency energy for ionizing the second gas may range from 600 watts to 800 watts, and a value of pressure in the chamber may range from 4 torrs to 6 torrs, such that plasma particles in an actual processing procedure are formed.

Alternatively, the second gas may be another gas, but a radius of a plasma particle formed after ionization of the gas should not be too large, so as to avoid excessive damage to the amorphous silicon layer 201. For example, the second gas may be any one or more of neon, argon, or oxygen, which is not specially limited herein.

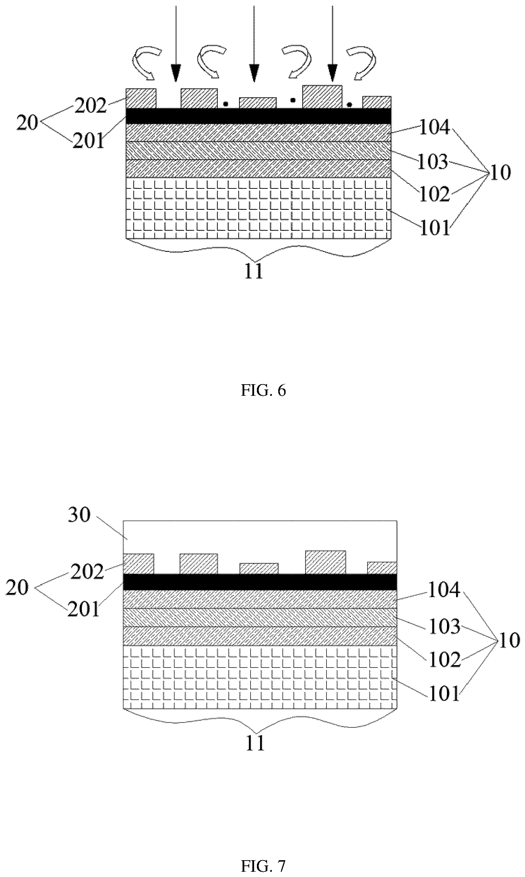

In step S150, the amorphous silicon layer 201 on which the plasma surface treatment has been performed and the dry etched silicon dioxide layer 202 are cleaned (as shown in FIG. 6).

Step S150 may include the following steps:
Step S1501. Blow across the amorphous silicon layer 201 on which the plasma surface treatment has been performed and the dry etched silicon dioxide layer 202, with a gas.
Step S 1502. Clean, with a liquid, the silicon dioxide layer 202 and the amorphous silicon layer 201, after the gas blows across the silicon dioxide layer and the amorphous silicon layer, thereby removing particle defects on surfaces of the amorphous silicon layer 201 and the silicon dioxide layer 202, thus also improving adhesion between the surface of the amorphous silicon layer 201 and the first photoresist layer 30.

The gas may be nitrogen or another gas and the liquid may be plasma water, which is not described in detail herein.

In step S160, a first photoresist layer 30 is coated on the composite layer 20 in the edge region 12 and the array region 11 (as shown in FIG. 7), and exposing and developing are performed. Because the impurity particles 2 and the labile compound 3 on the surface of the amorphous silicon layer 201 are removed, adhesion between the surface of the amorphous silicon layer 201 and the first photoresist layer 30 in the array region 11 is improved. This improves accuracy of pattern transfer during photolithography and avoids pattern defects.

Subsequently, a silicon oxide hard mask intermediate layer 40 and a second photoresist layer 50 are sequentially formed on a surface of the first photoresist layer 30 away from the substrate 10, and a second preset pattern is formed on the second photoresist layer 50. The manufacturing of the semiconductor device 1 further includes packaging, testing, and a plurality of other steps, but none of them are the focus of the present disclosure. Therefore, no detailed description is provided.

An implementation of the present disclosure provides a semiconductor device, where the semiconductor device is manufactured by the method of manufacturing a semiconductor device described in any one of the above. For example, the semiconductor device may be a chip or a MOS device, and the like, which are not listed herein.

The embodiments or implementations of this specification are described in a progressive manner, and each embodiment focuses on differences from other embodiments. The same or similar parts between the embodiments may refer to each other.

In the description of the specification, the description with reference to terms such as "an embodiment", "an illustrative embodiment", "some implementations", "an illustrative implementation" and "an example" means that the specific feature, structure, material or feature described in combination with the implementation(s) or example(s) is included in at least one implementation or example of the present disclosure.

In this specification, the schematic expression of the above terms does not necessarily refer to the same implementation or example. Moreover, the described specific feature, structure, material or characteristic may be combined in an appropriate manner in any one or more implementations or examples.

It should be noted that in the description of the present disclosure, the terms such as "center", "top", "bottom", "left", "right", "vertical", "horizontal", "inner" and "outer" indicate the orientation or position relationships based on the drawings. These terms are merely intended to facilitate description of the present disclosure and simplify the description, rather than to indicate or imply that the mentioned device or element must have a specific orientation and must be constructed and operated in a specific orientation. Therefore, these terms should not be construed as a limitation to the present disclosure.

It can be understood that the terms such as "first" and "second" used in the present disclosure can be used to describe various structures, but these structures are not limited by these terms. Instead, these terms are merely intended to distinguish one element from another.

The same elements in one or more drawings are denoted by similar reference numerals. For the sake of clarity, various parts in the drawings are not drawn to scale. In addition, some well-known parts may not be shown. For the sake of brevity, the structure obtained by implementing multiple steps may be shown in one figure. In order to make the understanding of the present disclosure more clearly, many specific details of the present disclosure, such as the structure, material, size, processing process and technology of the device, are described below. However, as those skilled in the art can understand, the present disclosure may not be implemented according to these specific details.

Finally, it should be noted that the above embodiments are merely intended to explain the technical solutions of the present disclosure, rather than to limit the present disclosure.

### Industrial Applicability

The method of manufacturing a semiconductor device thereof disclosed in the present disclosure can make a treated surface layer better bond with a photoresist, thereby improving accuracy of pattern transfer.

## Claims

1. A method of manufacturing a semiconductor device (1), **characterized by** comprising:
providing a substrate (10), wherein the substrate (10) comprises an array region (11) and an edge region (12);
forming a composite layer (20) on the substrate (10), wherein the composite layer (20) comprises an amorphous silicon layer (201) and a silicon dioxide layer (202), and the silicon dioxide layer (202) is located on a surface of the amorphous silicon layer (201) away from the substrate (10);
dry etching the silicon dioxide layer (202) in the array region (11) by using first plasma, to expose a part of the surface of the amorphous silicon layer (201) in the array region (11);
performing, by using second plasma, a plasma surface treatment on an exposed part of the surface of the amorphous silicon layer (201);
cleaning an amorphous silicon layer (201) on which the plasma surface treatment has been performed and a dry etched silicon dioxide layer (202); and
coating a first photoresist layer (30) on the composite layer (20) in the edge region (12) and the array region (11), and performing exposing and developing.

2. The method of manufacturing a semiconductor device (1) according to claim 1, wherein the cleaning an amorphous silicon layer (201) on which the plasma surface treatment has been performed and a dry etched silicon dioxide layer (202) comprises:
blowing across the amorphous silicon layer (201) on which the plasma surface treatment has been performed and the dry etched silicon dioxide layer (202), with a gas; and
cleaning, with a liquid, the silicon dioxide layer (202) and the amorphous silicon layer (201), after the gas blows across the silicon dioxide layer (202) and the amorphous silicon layer (201).

3. The method of manufacturing a semiconductor device (1) according to claim 2, wherein the gas is nitrogen, and the liquid is plasma water.

4. The method of manufacturing a semiconductor device (1) according to claim 1, wherein before the dry etching the silicon dioxide layer (202) in the array region (11) by using first plasma, the method of manufacturing a semiconductor device (1) further comprises:
ionizing a first gas in a chamber, to form the first plasma, wherein the first gas is a mixed gas of oxygen and hexafluorobutadiene or a mixed gas of oxygen and octafluorocyclobutane.

5. The method of manufacturing a semiconductor device (1) according to claim 4, wherein before the performing, by using second plasma, a plasma surface treatment on an exposed part of the surface of the amorphous silicon layer (201), the method of manufacturing a semiconductor device (1) further comprises:
ionizing a second gas in the chamber, to form the second plasma, wherein the second gas is nitrous oxide or helium.

6. The method of manufacturing a semiconductor device (1) according to claim 5, wherein when the second gas is nitrous oxide, a gas flow rate of the second gas is 4000 standard ml/min to 6000 standard ml/min; and
when the second gas is helium, a gas flow rate of the second gas is 1000 standard ml/min to 3000 standard ml/min.

7. The method of manufacturing a semiconductor device (1) according to claim 5, wherein a value of radio frequency energy for ionizing the second gas ranges from 600 watts to 800 watts.

8. The method of manufacturing a semiconductor device (1) according to claim 5, wherein a value of pressure in the chamber ranges from 4 torrs to 6 torrs.

9. The method of manufacturing a semiconductor device (1) according to claim 5, wherein the second gas is any one or more of neon, argon, or oxygen.

## Patentansprüche

1. Verfahren zur Herstellung eines Halbleiterbauelements (1), **dadurch gekennzeichnet, dass** es Folgendes umfasst:
Bereitstellen eines Substrats (10), wobei das Substrat (10) einen Feldbereich (11) und einen Randbereich (12) umfasst;
Bilden einer Verbundschicht (20) auf dem Substrat (10), wobei die Verbundschicht (20) eine amorphe Siliziumschicht (201) und eine Siliziumdioxidschicht (202) umfasst und die Siliziumdioxidschicht (202) auf einer Oberfläche der amorphen Siliziumschicht (201) entfernt von dem Substrat (10) angeordnet ist;
Trockenätzen der Siliziumdioxidschicht (202) im Feldbereich (11) unter Verwendung eines ersten Plasmas, um einen Teil der Oberfläche der amorphen Siliziumschicht (201) im Feldbereich (11) freizulegen;
Durchführen einer Plasma-Oberflächenbehandlung mit Hilfe eines zweiten Plasmas auf einem freiliegenden Teil der Oberfläche der amorphen Siliziumschicht (201);
Reinigung einer amorphen Siliziumschicht (201), auf der die Plasma-Oberflächenbehandlung durchgeführt wurde, und einer trockengeätzten Siliziumdioxidschicht (202); und
Beschichten der Verbundschicht (20) im Randbereich (12) und im Feldbereich (11) mit einer ersten Photolackschicht (30) und Durchführen von Belichtung und Entwicklung.

2. Verfahren zur Herstellung eines Halbleiterbauelements (1) nach Anspruch 1, wobei das Reinigen einer amorphen Siliziumschicht (201), auf der die Plasma-Oberflächenbehandlung durchgeführt wurde, und einer trockengeätzten Siliziumdioxidschicht (202) umfasst:
Durchblasen der amorphen Siliziumschicht (201), auf der die Plasma-Oberflächenbehandlung durchgeführt wurde, und der trockengeätzten Siliziumdioxidschicht (202) mit einem Gas; und
Reinigung der Siliziumdioxidschicht (202) und der amorphen Siliziumschicht (201) mit einer Flüssigkeit, nachdem das Gas über die Siliziumdioxidschicht (202) und die amorphe Siliziumschicht (201) geblasen wurde.

3. Verfahren zur Herstellung eines Halbleiterbauelements (1) nach Anspruch 2, wobei das Gas Stickstoff ist und die Flüssigkeit Plasmawasser ist.

4. Verfahren zur Herstellung eines Halbleiterbauelements (1) nach Anspruch 1, wobei das Verfahren zur Herstellung eines Halbleiterbauelements (1) vor dem Trockenätzen der Siliziumdioxidschicht (202) in dem Feldbereich (11) unter Verwendung eines ersten Plasmas ferner umfasst:
Ionisierung eines ersten Gases in einer Kammer, um das erste Plasma zu bilden, wobei das erste Gas ein Mischgas aus Sauerstoff und Hexafluorbutadien oder ein Mischgas aus Sauerstoff und Octafluorcyclobutan ist.

5. Verfahren zur Herstellung eines Halbleiterbauelements (1) nach Anspruch 4, wobei das Verfahren zur Herstellung eines Halbleiterbauelements (1) vor der Durchführung einer Plasma-Oberflächenbehandlung eines freiliegenden Teils der Oberfläche der amorphen Siliziumschicht (201) unter Verwendung eines zweiten Plasmas weiterhin umfasst:
Ionisierung eines zweiten Gases in der Kammer, um das zweite Plasma zu bilden, wobei das zweite Gas Distickstoffoxid oder Helium ist.

6. Verfahren zur Herstellung eines Halbleiterbauelements (1) nach Anspruch 5, wobei, wenn das zweite Gas Distickstoffoxid ist, die Gasflussrate des zweiten Gases 4000 Standard-ml/min bis 6000 Standard-ml/min beträgt; und
wenn das zweite Gas Helium ist, der Gasdurchsatz des zweiten Gases 1000 Standard-ml/min bis 3000 Standard-ml/min beträgt.

7. Verfahren zur Herstellung eines Halbleiterbauelements (1) nach Anspruch 5, wobei ein Wert der Hochfrequenzenergie zur Ionisierung des zweiten Gases im Bereich von 600 Watt bis 800 Watt liegt.

8. Verfahren zur Herstellung eines Halbleiterbauelements (1) nach Anspruch 5, bei dem der Druck in der Kammer im Bereich von 4 Torr bis 6 Torr liegt.

9. Verfahren zur Herstellung eines Halbleiterbauelements (1) nach Anspruch 5, wobei das zweite Gas eines oder mehrere der Gase Neon, Argon oder Sauerstoff ist.

## Revendications

1. Procédé de fabrication d'un dispositif à semi-conducteur (1), **caractérisé en ce qu'**il comprend :
la fourniture d'un substrat (10), dans lequel le substrat (10) comprend une région de réseau (11) et une région de bord (12) ;
la formation d'une couche composite (20) sur le substrat (10), dans lequel la couche composite (20) comprend une couche de silicium amorphe (201) et une couche de dioxyde de silicium (202), et la couche de dioxyde de silicium (202) est située sur une surface de la couche de silicium amorphe (201) éloignée du substrat (10) ;
la gravure à sec de la couche de dioxyde de silicium (202) dans la région de réseau (11) à l'aide d'un premier plasma, afin d'exposer une partie de la surface de la couche de silicium amorphe (201) dans la région de réseau (11) ;
la réalisation, à l'aide d'un second plasma, d'un traitement de surface par plasma sur une partie exposée de la surface de la couche de silicium amorphe (201) ;
le nettoyage d'une couche de silicium amorphe (201) sur laquelle le traitement de surface par plasma a été effectué et d'une couche de dioxyde de silicium gravée à sec (202) ; et
le revêtement d'une première couche de résine photosensible (30) sur la couche composite (20) dans la région de bord (12) et la région de réseau (11), et la réalisation de l'exposition et du développement.

2. Procédé de fabrication d'un dispositif à semi-conducteur (1) selon la revendication 1, dans lequel le nettoyage d'une couche de silicium amorphe (201) sur laquelle le traitement de surface par plasma a été effectué et d'une couche de dioxyde de silicium gravée à sec (202) comprend :
le soufflage d'un gaz sur la couche de silicium amorphe (201) sur laquelle le traitement de surface par plasma a été effectué et sur la couche de dioxyde de silicium gravée à sec (202) ; et
le nettoyage, avec un liquide, de la couche de dioxyde de silicium (202) et de la couche de silicium amorphe (201), après que le gaz a été soufflé sur la couche de dioxyde de silicium (202) et la couche de silicium amorphe (201).

3. Procédé de fabrication d'un dispositif à semi-conducteur (1) selon la revendication 2, dans lequel le gaz est de l'azote et le liquide est de l'eau de plasma.

4. Procédé de fabrication d'un dispositif à semi-conducteur (1) selon la revendication 1, dans lequel, avant la gravure à sec de la couche de dioxyde de silicium (202) dans la région de réseau (11) à l'aide d'un premier plasma, le procédé de fabrication d'un dispositif à semi-conducteur (1) comprend en outre :
l'ionisation d'un premier gaz dans une chambre, pour former le premier plasma, dans lequel le premier gaz est un gaz mixte d'oxygène et d'hexafluorobutadiène ou un gaz mixte d'oxygène et d'octafluorocyclobutane.

5. Procédé de fabrication d'un dispositif à semi-conducteur (1) selon la revendication 4, dans lequel avant de réaliser, à l'aide d'un second plasma, un traitement de surface par plasma sur une partie exposée de la surface de la couche de silicium amorphe (201), le procédé de fabrication d'un dispositif à semi-conducteur (1) comprend en outre :
l'ionisation d'un second gaz dans la chambre, pour former le second plasma, dans lequel le second gaz est de l'oxyde nitreux ou de l'hélium.

6. Procédé de fabrication d'un dispositif à semi-conducteur (1) selon la revendication 5, dans lequel, lorsque le second gaz est de l'oxyde nitreux, un débit de gaz du second gaz va de 4000 ml/min standard à 6000 ml/min standard ; et
lorsque le second gaz est de l'hélium, un débit de gaz du second gaz va de 1000 ml/min standard à 3000 ml/min standard.

7. Procédé de fabrication d'un dispositif à semi-conducteur (1) selon la revendication 5, dans lequel une valeur de l'énergie en radiofréquence pour l'ionisation du second gaz va de 600 watts à 800 watts.

8. Procédé de fabrication d'un dispositif à semi-conducteur (1) selon la revendication 5, dans lequel une valeur de la pression dans la chambre est comprise va de 4 torrs à 6 torrs.

9. Procédé de fabrication d'un dispositif à semi-conducteur (1) selon la revendication 5, dans lequel le second gaz est un ou plusieurs gaz quelconques parmi le néon, l'argon ou l'oxygène.
